# EUROPEAN PATENT APPLICATION

(11) **EP 4 546 397 A1**
(43) Date of publication of application: **30.04.2025**
(21) Application number: 23206357.8
(22) Date of filing: 27.10.2023
(51) Int. Cl.: H01L 21/306

(54) **METHOD FOR BACKSIDE THINNING OF AN INTEGRATED CIRCUIT**

(71) Applicant: IHP GmbH - Innovations for High Performance Microelectronics / Leibniz-Institut für innovative Mikroelektronik, 15236 Frankfurt (Oder) (DE)
(72) Inventor: Herfurth, Norbert, 15236 Frankfurt (Oder) (DE); Boit, Christian, 13505 Berlin (DE); Zwicker, Gerfried, 14057 Berlin (DE); Adesunkanmi, Awwal Adeniyi, 15236 Frankfurt (Oder) (DE)
(74) Representative: Eisenführ Speiser

(57) **Abstract**

The present invention relates to a method for backside thinning of an integrated circuit, herein referred to as IC. The method comprises the steps of:
- providing the IC, wherein the IC comprises a Si-containing substrate forming the backside of the IC, a Si-based insulator-containing shallow trench isolation, herein referred to as STI, arranged on the Si-containing substrate and one or more functional IC components arranged within the STI and/or on the STI opposite the Si-containing substrate,
- providing a polishing pad,
- applying a slurry onto the polishing pad and/or the backside of the IC, the slurry being configured to provide an at least Si-selective removal upon exertion of a mechanical shear force,
- bringing the backside of the IC and the polishing pad into contact with each other, and
- thinning the IC to a thickness of the Si-containing substrate of 1 µm or less by exerting a mechanical shear force to the IC's backside while maintaining the contact between the IC and the polishing pad up.

## Description

### TECHNICAL FIELD

The present invention relates to a method for backside thinning of an integrated circuit making use of a polishing pad and a slurry.

### BACKGROUND OF THE INVENTION

An integrated circuit (IC) typically comprises a set of electronic circuits arranged on a substrate that in most cases is made of silicon (Si). Such an IC typically comprises various different electronic components such as transistors, resistors, capacitors and the like. IC's can be fabricated with mass production capabilities and at comparatively low costs using, e.g., established Si technologies such as complementary metal-oxide-semiconductor (CMOS) technology. A typical process step in CMOS technology of a 250 nm process or smaller is the fabrication of a shallow trench isolation (STI), also known as box isolation technique, as part of the IC, which is intended to prevent electric current leakage between adjacent functional components of the IC, e.g., semiconductor device components.

To ensure that fully functional IC's are used in electronic and optoelectronic devices, it is standard to carry out failure analysis. Such failure analysis typically requires contactless fault isolation techniques with optical interaction through the IC's backside. This often includes thinning of the IC's backside which involves a determination of an appropriate endpoint for the thinning.

An exemplary thinning process for subsequent failure analysis is described in US 2013/0271169 A1. The therein described is a process that involves applying energy, e.g., heat, to an example electronic device whereby any die bow, curvature, warpage or other non-planar surface conditions associated with one or more semiconductor dies forming part of the example electronic device may be mitigated. According to US 2013/0271169 A1, such mitigation can be helpful in the subsequent processing of the example electronic device because of the relaxation of the constituent components of the example electronic device, whereby the internal stress or strain created in the semiconductor dies during the device's manufacturing or assembly flow are advantageously reduced. Furthermore, it is stated that the semiconductor die(s) of the example electronic device may be rendered more amenable for subsequent treatments, e.g., including preparation of the sample dies for one or more of failure analysis techniques, without compromising the integrity of the die(s), e.g., mechanical breakage, chipping, cracking, delamination, etc. of the die itself as well as without compromising any electrical contact structures such as bonding wires, pads, and the like.

Yet, it is still desirable to further improve the thinning of IC's to be even more accurate and reliable, in particular, even with decreasing sizes of the IC's that are under steady development.

### SUMMARY OF THE INVENTION

The present invention is based on the objective to provide an improved process for backside thinning of an IC.

According to the present invention, a method for backside thinning of an IC is proposed. The method comprises the steps of:
- providing the IC, wherein the IC comprises a Si-containing substrate forming the backside of the IC, a Si-based insulator-containing STI arranged on the Si-containing substrate and one or more functional IC components arranged within the STI and/or on the STI opposite the Si-containing substrate,
- providing a polishing pad,
- applying a slurry onto the polishing pad and/or the backside of the IC, the slurry being configured to provide an at least Si-selective removal upon exertion of a mechanical shear force,
- bringing the backside of the IC and the polishing pad into contact with each other, and
- thinning the IC to a thickness of the Si-containing substrate of 1 µm or less by exerting a mechanical shear force to the IC's backside while maintaining the contact between the IC and the polishing pad up.

The invention is based on the recognition that for the last decades, failure analysis worked well based on near infra-red optics, keeping silicon transparent through the full IC backside. Failure analysis includes obtaining information about the functionality of an IC to improve IC manufacturing. Furthermore, also when it comes to security aspects, the IC backside may play an important role. That is, it is possible to use, e.g., near infra-red optics, to access information stored in the IC. In both cases, i.e., for failure analysis and for accessing the stored information of an IC, the IC backside needs to be substantially transparent for the electromagnetic radiation to be used. Yet, miniaturization, e.g., to single nm nodes, sets a requirement for shorter wavelengths to still be able to achieve an adequate resolution, e.g., in a failure analysis or for accessing the stored information of an IC.

The inventors have recognized that using visible light potentially allows to further improve the achievable resolution especially when combined with a GaP solid immersion lens (SIL). For example, using visible light with a wavelength of 550 nm would result in a penetration depth of approximately 1 µm. Accordingly, a remaining thickness of the substrate on the IC's backside should not to be much greater than 1 µm to allow transmission of sufficient signal intensity. Yet, a thickness 1 µm is comparatively thin and a corresponding thinning process would not provide a reliable endpoint where to stop such that the functional components of the IC are not damaged. Accordingly, realising a reliable process stop with this minimal margin of 1 µm generally is a very challenging task. Common sample preparation techniques like laser-based thinning typically do not provide a reliable process stop.

Furthermore, backside thinning of IC's down to the STI level generally requires Si removal processes with high selectivity to SiOz. Plasma-based processes like reactive ion etching (RIE) with high Si etch rate, but low SiOz etch rate typically have the disadvantage, that local Si etching does not stop when exposing STI. The inventors have recognized that this can only be achieved by using removal processes relying on horizontal shear forces like chemical-mechanical polishing (CMP).

With the method according to the invention it is possible to prepare an IC down to STI level with a high selective endpoint. By being able to reliably prepare an IC down to STI level, the proposed method according to the invention unlocks the possibility of efficiently probing single devices from the backside by using visual light or an electron-beam (e-beam). In particular, the proposed method allows reliably accessing the STI level of a single die.

This is achieved with the proposed method in that a highly selective slurry is used to remove the Si substrate starting from the backside under exerting of a mechanical shear force. Since the slurry is selective to Si (rather than to the Si-based insulator of the STI such as SiO), the STI containing a Si-based insulator provides a stop to the thinning process. Because of using chemically selective active slurries it is thus possible to realize a sample preparation endpoint in an accurate and reliable manner. By adjusting the amount of the mechanical shear force and the resulting material removal rate (MRR) it is possible to ensure that the STI level stays intact. For example, with the proposed method it is possible to realize a MMR of Si-to-SiO that is larger than 500:1.

It is a particular advantage of the proposed method that even after thinning, functional components of the IC may remain their full functionality. This allows testing the functionality of the IC or accessing information stored in the IC by utilizing interaction of the IC with visual light, e.g., with wavelengths of 300 nm to 850 nm, or an e-beam even after thinning of the IC's backside to 1 µm or less.

In the method, the Si-based insulator-containing STI may comprise SiN, SiO, or SiOz. An at least Si-selective removal may refer to a Si-selective removal or a SiGe-selective removal. The Si-containing substrate may be a single crystalline, polycrystalline or amorphous Si substrate, a SiGe substrate, or a SiC substrate. Functional components may be, e.g., an electronic circuit, or an electronic or optoelectronic component such as a transistor, resistor, capacitor, diode, or the like, or photonic components such as a waveguide.

Preferably, the slurry has low abrasive characteristics. Preferably, the slurry is configured to develop a Si-selective removal in comparison to a Si-based insulator material when a mechanical shear force is applied.

Preferably, the slurry comprises abrasive particles at a percentage of 5 % or less. For example, the slurry may comprise abrasive particles at a percentage of 1 % or less, 0.5 % or less, 0.1 % or less, even 0.01 % or less. In particular, the slurry may be free of abrasive particles, i.e., may comprise abrasive particles at a percentage of 0 %.

In comparison to standard slurries that comprise a water dispersion with colloidal nano-abrasives as the mechanical component and chemicals to adjust a pH value in order to achieve chemical attack, the slurry used in the proposed method, preferably, has a comparatively low amount of abrasive particles or even no abrasive particles at all. Thereby, and in contrast to known slurries, a high Si-selectivity can be achieved. The inventors have thus recognized that a high selectivity to Si, i.e., a low polishing rate of, e.g., SiO, can be achieved by reducing the mechanical portion of the removal attack by reducing the abrasive content to a very low percentage or to zero. Preferably, the abrasive particles, if present, have an average diameter of 100 nm or less, such as 50 nm or less, or even 20 nm or less. Such slurries with a low content of abrasives may develop a Si-selective removal upon exertion of a mechanical shear force. Abrasive particles, if present, may comprise silica (SiOz), ceria (CeO₂), alumina (Al₂O₃) or the like. The abrasive particles may be colloidal which means precipitated from a (saturated) liquid, e.g. water glass. The abrasive particles may be fumed which means that the particles are the ash from the combustion of a silicon containing gas with oxygen (e.g. SiH₂Cl₂). The abrasive particles may also be calcined and ground particles obtained from the heat treatment of a base material and the subsequent grinding. Colloidal particles, generally, are round and do not make scratches by mainly rolling on the surface but have lower removal rate. Fumed particles are flake-like, have high removal rate but may make scratches. Calcined and ground particles, e.g., made of Al₂O₃, may make scratches at high removal rates. Colloidal particles are often preferred because the grain size can generally be adjusted very well by stopping the precipitation process.

Preferably, in the method, a constant supply of the slurry is maintained. Preferably the slurry is applied in the centre of the polishing pad. In the method, the slurry may be transported between the backside of the IC and the polishing pad due to the relative movements of both.

The method, preferably, comprises - prior bringing the backside of the IC and the polishing pad into contact with each other - mechanically thinning the Si-containing substrate to a thickness of 50 µm or less. For example, the Si-containing substrate may be mechanically thinned to a thickness of 10 µm to 50 µm, e.g., 20 µm or less, or 15 µm or less. Mechanical thinning may be realised through grinding.

Preferably, in the method, the backside of the IC and the polishing pad are brought into contact with each other with a down pressure of 1 PSI to 20 PSI, preferably, 1 PSI to 10 PSI, even more preferably 1 PSI to 5 PSI. The table depicted in the following exemplary provides several values for a pay load in [g], a pressure in [N/mm²] and pressure in [PSI] that have been applied during testing thinning processes of IC's according to the proposed method.

| **Pay Load (g)** | **Pressure (N/mm²)** | **Pressure (PSI)** |
|---|---|---|
| 0 | 7.56 | 2.74 |
| 50 | 7.96 | 2.89 |
| 100 | 8.49 | 3.08 |
| 150 | 8.98 | 3.26 |
| 200 | 9.43 | 3.42 |
| 250 | 9.74 | 3.53 |
| 300 | 10.54 | 3.82 |
| 350 | 11.03 | 4.00 |
| 400 | 11.48 | 4.16 |
| 450 | 11.97 | 4.34 |
| 500 | 12.45 | 4.52 |
| 550 | 12.94 | 4.69 |
| 600 | 13.43 | 4.87 |
| 650 | 13.92 | 5.05 |

The reason for having a non-zero pressure at a pay load of zero is that this determined pressure originates from the employed sample holder and the arm holding the sample holder. Preferably, in the method, the polishing pad is rotated with a rotational speed of 10 to 300 rpm (rounds per minute). Preferably, the polishing pad is rotated with a velocity of 0.3 m/s to 3 m/s in the centre of the IC. Preferably, the IC is arranged not in the centre of the polishing pad but at a distance radially spaced apart from the polishing pad centre. During the thinning, the IC may be rotated around its central axis and also radially relative to the polishing pad and in contact with the polishing pad. Thereby, the position of the IC on the polishing pad can be constantly changed to ensure an improved thinning, e.g., with a relatively constant MRR. Forfinal polishing, i.e., up to a thickness of 1 µm or less, a radial position of the IC on the polishing pad may be kept constant to improve the control over the thinning. Ex-situ or in-situ, i.e., prior to or during the method, the polishing pad may be conditioned with a conditioning disk for removing debris and refreshing the surface of the pad. The polishing pad may be pre-wetted, e.g., with water, to improve a homogeneous distribution of the slurry on the polishing pad. Preferably, the slurry is applied in the centre of the polishing pad and distributed radially outwards due to ration of the polishing pad.

The polishing pad may have a diameter of 0.5 cm to 100 cm, e.g., of 20 cm to 100 cm. The polishing pad may be cut to a desired size for carrying out the method. For example, the polishing pad may have a size of 5 cm to 20 cm. The polishing pad may comprise felted fibres impregnated with polymeric binder, may comprise porous film coated on a supporting substrate, may comprise a microporous polymer sheet, and/or may comprise a nonporous polymer sheet with surface microstructure. Additionally or alternatively, the polishing pad may comprise nylon tissue. In particular, the aforementioned polishing pad configurations allow a distribution of the slurry between the IC and polishing pad, while the IC and the polishing pad are in contact with each other for the thinning. Furthermore, the aforementioned polishing pad configurations are suitable for providing a mechanical counterforce to the IC for the thinning.

Preferably, in the method, the Si-containing substrate is removed with a material removal rate of 0.1 µm/min to 10 µm/min, preferably, of 0.2 µm/min to 5 µm/min, even more preferably, of 0.3 µm/min to 3 µm/min, e.g., of 0.4 µm/min to 1 µm/min. 0.4 µm/min to 1 µm/min is preferred to provide good control of the thinning process, e.g., by reliably stopping the process at a certain thickness
Preferably, in the method, the slurry is configured to enable a Si-to-SiO removal rate ratio of at least 100:1, e.g. of at least 500:1 or more, preferably, of 1000:1 or more. In particular, with a MRR ratio of at least 100:1, e.g. of at least 500:1 or more, preferably, of 1000:1 or more, a fast and reliable preparation of the IC backside down to STI level is possible.

Preferably, the slurry comprises an alkali to provide the Si-selective removal. The alkali may be, e.g., Potassium Hydroxide (KOH) or Tetramethylammonium Hydroxide (TMAH). Preferably, the slurry comprises a cationic or non-ionic polymer additive that is configured to at least partially suppress static etching of Si. For example, a cationic surfactant such as poly (diallyldimethylammonium chloride (PDADMAC) can be used as an additive. When using a slurry with an alkaline chemistry like KOH or TMAH, which have a high etch rate of Si, static etching of Si, i.e., removal without mechanical action, may be suppressed by cationic or non-ionic polymer additives. They may adsorb on the Si and prevent etching and, during polishing, may be wiped away by the polishing pad, allowing a short, controlled etching before the additive is adsorbed anew. Bases like KOH or TMAH typically show very low SiO etch rates, so that a high selectivity may be achievable with such a formulation.

Preferably, the IC has a base area of no more than 100 mm x 100 mm, e.g., of no more than 20 mm x 20, preferably, of no more than 15 cm x 15 cm, even more preferably, of no more than 3 cm x 3 cm. Preferably, the IC has a base area of at least 0.5 mm x 0.5 mm.

In the method, it is possible that the IC is arranged on a sample holder with its backside facing away from the sample holder, wherein a distance between the IC's backside and the sample holder is at least 40 µm. This may ensure that the IC's backside is evenly thinned and that the polishing pad does not contact the sample holder.

Preferably, for bringing the backside of the IC and the polishing pad into contact with each other, the IC is moved towards the polishing pad. For example, there may be an arm holding the IC and the arm may be a robot arm that may be controlled to automatically move the IC towards the polishing pad. It is also possible that the arm is configured such that it can be moved manually to bring the IC in contact with the polishing pad.

Additionally, or alternatively, for bringing the backside of the IC and the polishing pad into contact with each other, the polishing pad may be moved towards the IC. It is thus also possible that both, polishing pad and IC are arranged movably to each another such that both, the IC and the polishing pad can be moved to establish a contact between them. Yet it is also possible that only the polishing pad can be moved towards the IC to bring the polishing pad in contact with the IC.

Preferably, the method comprises determining a current thickness of the Si-containing substrate at one or more selected time instances using an optical measurement. The optical measurement can be performed in-situ, i.e., while thinning, or ex-situ, i.e., while the thinning is temporarily stopped. With the optical measurement, it is possible to regularly check the current thickness of the IC backside. An optical measurement can include reflectometry or interferometry. Determining a current thickness of the Si-containing substrate may include that measurement data or image data obtained from the optical measurement are used as input for a trained neural network. In particular, the neural network is trained to obtain measurement data or image data obtained from the optical measurement as input and to provide a current thickness of the Si-containing substrate as output. For example, the trained neural network may be a multi-scale neural network or a recurrent neural network (RNN) such as, but not limited to, a gated recurrent unit (GRU) recurrent neural network or a long short-term memory (LSTM) recurrent neural network. Alternatively, the neural network may be a convolutional neural network (CNN). The neural network may be trained using training data, e.g., obtained via optical measurements for determining a current thickness of the Si-containing substrate. Accordingly, the training data may include measurement data or image data obtained from an optical measurement of a current thickness of the Si-containing substrate. The training of the neural network, preferably, is supervised and a backpropagation-algorithm may be applied for training the neural network.

Based on the determined current thickness of the Si-containing substrate, thinning parameters such as the down pressure or the rotational speed may be adjusted to adapt the MRR.

It shall be understood that a preferred embodiment of the present invention can also be any combination of the dependent claims or above embodiments with the respective independent claim.

These and other aspects of the invention will be apparent from and elucidated with reference to the embodiments described hereinafter with reference to the drawings.

### BRIEF DESCRIPTION OF THE DRAWINGS

- Fig. 1:: schematically and exemplary shows setup for backside thinning of an integrated circuit;
- Fig. 2:: shows a flow diagram representing a method for backside thinning of an integrated circuit;
- Fig. 3:: schematically and exemplary shows an integrated circuit before thinning;
- Fig. 4:: schematically and exemplary shows the integrated circuit of Fig. 3 after thinning;
- Fig. 5:: schematically and exemplary a bare die mounting with additional spacer die to increase a distance to a sample holder;
- Fig. 6:: shows in a) and b) optical images of a partly 12 mm x 8 mm STI thinned bare die in a), and showing the additionally exposed STI level after 10 minutes additional process time in b);
- Fig. 7:: shows an optical image of a packaged IC of which the housing has been opened to access the IC;
- Fig. 8:: shows an optical image of the packaged IC of Fig. 7 from a different perspective and with thinned IC backside;
- Fig. 9:: shows in a) an optical image of an optical analysis of an exposed STI area, and in b), am e-beam image showing the structured STI area;
- Fig. 10:: visualises a perfect edge retention of the 15 µm thick free hanging corner; and
- Fig. 11: shows in a) and b) an optical image of a flip-chip mounted commercial sub 50nm chip thinned down to STI level within less than 4 hours processing, wherein b) shows an excerpt of the image shown in a).

### DETAILED DESCRIPTION OF EMBODIMENTS

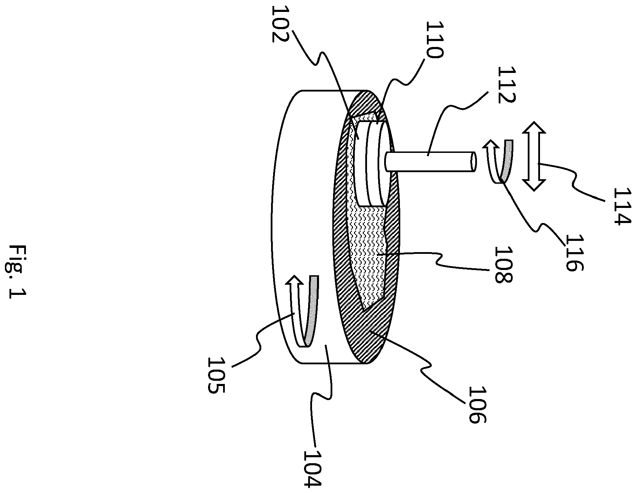

Figure 1 schematically and exemplary shows a setup 100 for backside thinning of an integrated circuit 102. The setup 100 comprises a plate 104 that can be rotated (as indicated by arrow 105) and that holds a polishing pad 106. Of course, a rotation of plate 104 in the inverse direction compared to arrow 105 may be feasible. During operation of the setup 100, a slurry 108 is applied onto the polishing pad 106 and distributed radially outwards on the polishing pad 106 due to an exerted centrifugal force.

The IC 102 is in contact with the polishing pad 106 and the slurry 108 is transported between the IC 102 and the polishing pad 108. The IC 102 is mounted to a sample holder 110 that in turn is held by an arm 112 that rotates the IC 102 around its central axis (as indicated by arrow 116) and that also moves the IC 102 radially (as indicated by arrow114) relative to the polishing pad 106 in orderto ensure homogenous thinning of the IC backside. Again, of course using a rotation of IC 102 in the inverse direction compared to arrow 116 may also be possible. It is also possible that the plate 104 and the IC 102 are rotated in opposite directions. Due to mechanical shear forces exerted on the backside of the IC 102, the IC 102 can be thinned in a controllable manner down to a thickness of 1 µm or less.

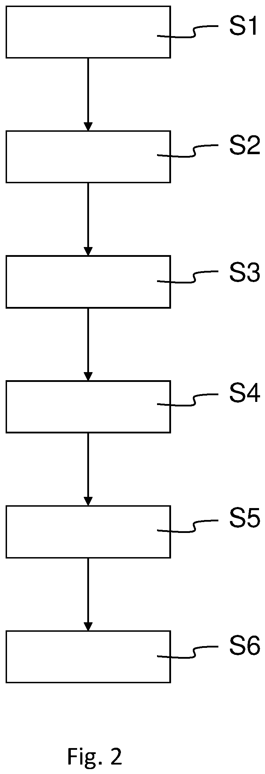

Figure 2 shows a flow diagram representing a method for backside thinning of an IC. In the method, an IC is provided (step S1). The IC has a Si-containing substrate, e.g., made of Si or SiGe, forming the backside of the IC. Arranged on the substrate, there is a Si-based insulator-containing STI, e.g., made of SiO or SiN. That is, the STI is made of or comprises a Si-based insulator. Furthermore, the IC comprises one or more functional IC components arranged within the STI and/or on the STI opposite the Si-containing substrate. In the method, also a polishing pad is provided (step S2). The polishing pad can be rotated and is configured such that a slurry can be transported radially outwards on the polishing pad upon exertion of a centrifugal force caused by the rotational movement of the polishing pad. Onto the polishing pad and/or the backside of the IC, a slurry is applied (step S3). The slurry is configured to provide an at least Si-selective removal upon exertion of a mechanical shear force and may comprise an alkali to provide the Si-selective removal.

The IC backside and the polishing pad are brought into contact with each other (step S4). While maintaining the contact, the polishing pad and the IC are rotated around the respective central axis and the IC is furthermore moved radially relative to the polishing pad. Thereby, the IC backside is thinned (step S5). During the thinning process, e.g., in-situ or ex-situ, a current thickness of the Si-containing substrate at one or more selected time instances is determined using an optical measurement such as reflectometry or interferometry (step S6). Thereby, it is possible to reliably and accurately control the thinning of the IC backside down to a thickness of 1 µm or less.

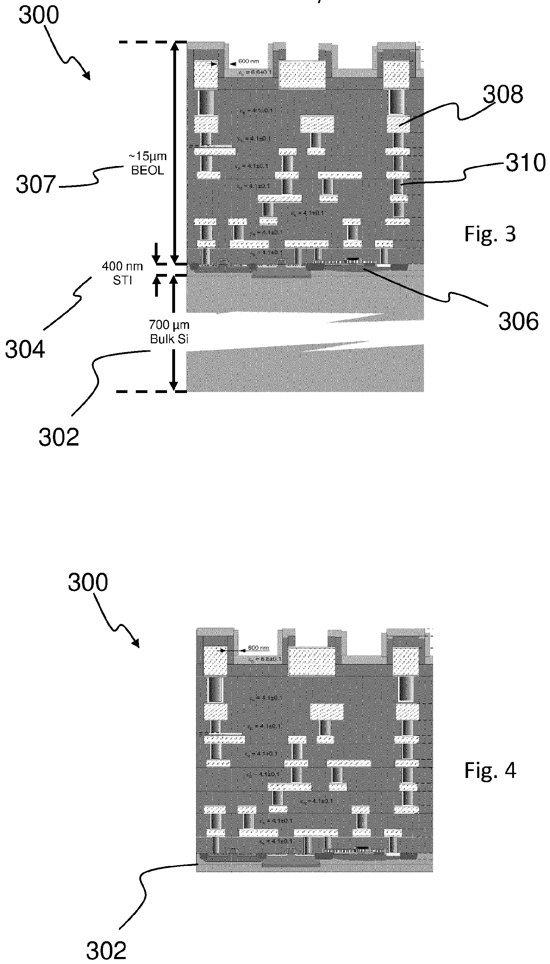

Figure 3 schematically and exemplary shows an IC 300 before thinning. The IC has a bulk Si substrate 302 with a thickness of 700 µm. On top of the substrate 302, a STI 304 made of SiO is arranged with a thickness of 400 nm. Within and on top of the STI 304, the front-end-of-line (FEOL) is arranged including several functional IC components 306 such as transistors, resistors and the like. The FEOL is followed by the back-end-of-line (BEOL) 307 comprising electrical contacts 308, insulating layers (dielectrics), and metal levels. The different metal levels are connected by vias 310. As shown in figure 4, after thinning of the IC 300, the thickness of the substrate 302 has been reduced to less than 1 µm.

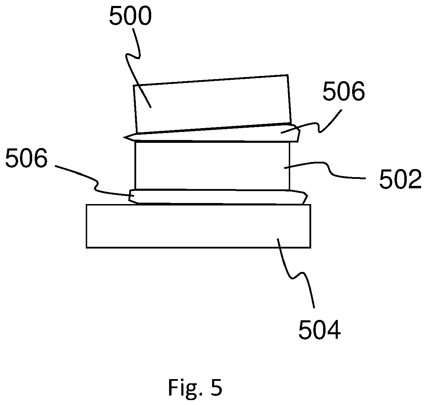

Figure 5 schematically and exemplary shows an IC 500 mounted to an additional spacer die 502 to increase a distance of more than 300 µm to a sample holder 504. The IC 500 is mounted with the additional spacer-chip 502 using mounting wax 506 with a thickness of about 20 µm on the sample holder 504 as well as in between both chips 500, 502.

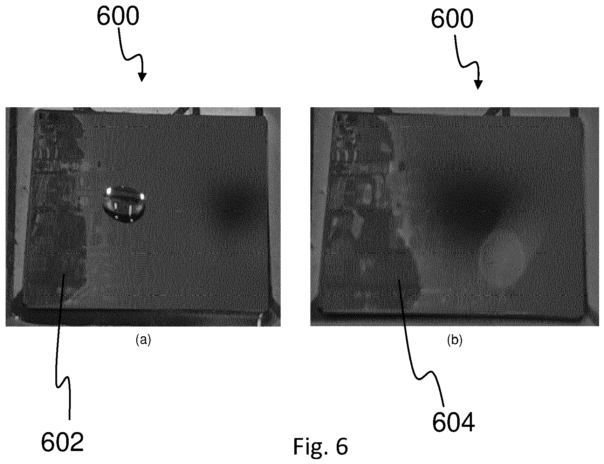

Figure 6 shows in a) and b) optical images of a partly 12 mm x 8 mm STI thinned bare die 600. In particular, in a), already parts of the STI level 602 are exposed. In b), it is visible after 10 minutes additional process time that even further parts 604 of the STI level are exposed.

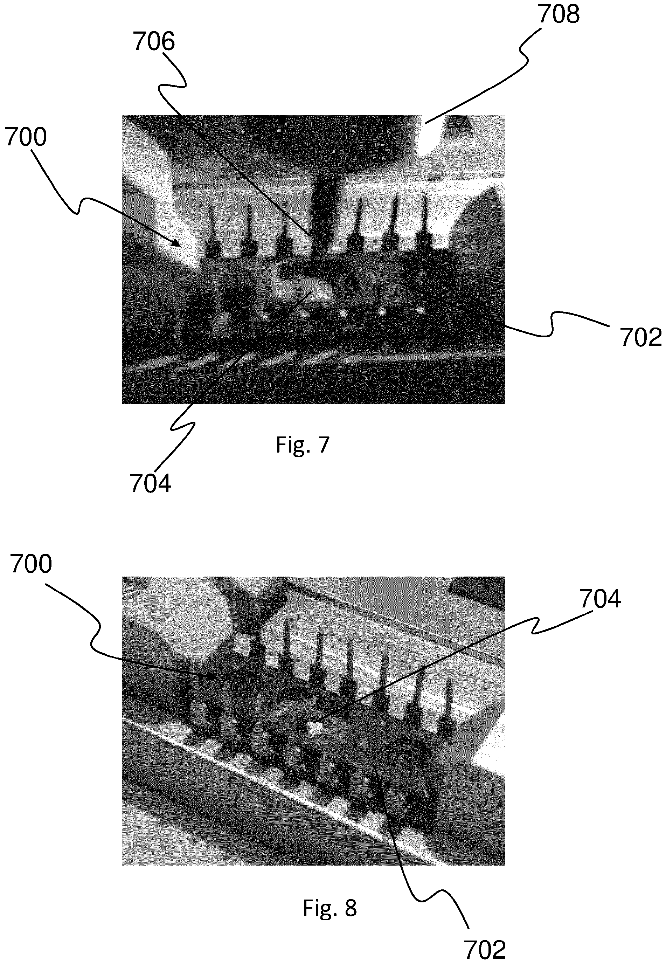

Figure 7 shows an optical image of a packaged IC 700 of which the housing 702 has been opened to access the IC 704. In particular, the package is a "dual inline package (DIP)" and the packaged IC 700 is a dual inline packaged IC. Furthermore visible is an arm 708 holding a polishing pad 706. The arm 708 can move the polishing pad 706 into the opening to access the IC 704. The polishing pad 706 can then be rotated and moved along the IC 704 while maintaining contacts between the IC 704 and the polishing pad 706 for thinning the IC's backside down to a thickness of 1 µm or less. Figure 8 shows an optical image of the packaged IC 700 of figure 7 from a different perspective and with thinned IC backside. In this view, it is visible that the IC backside has been thinned down to STI level.

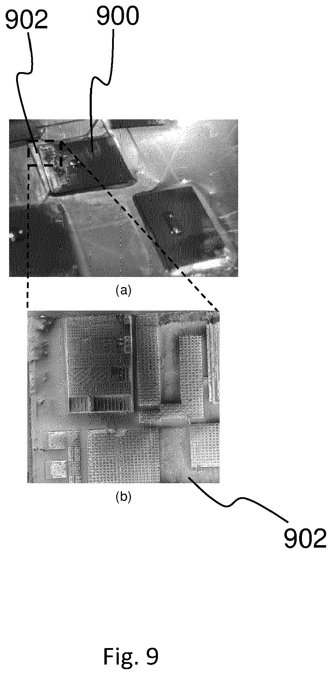

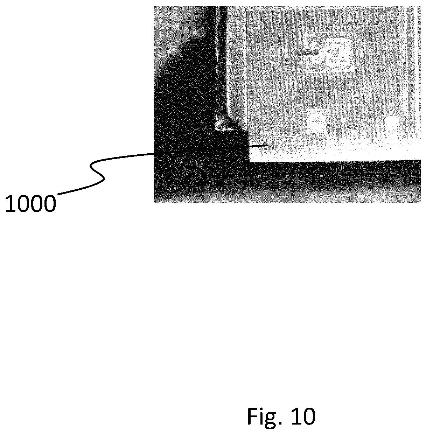

Figure 9 shows in a) an optical image of an optical analysis of an IC 900 having an exposed STI area 902. In b), an e-beam image of an excerpt of the IC 900 is showing the structured STI area 902. As can be obtained from figure 9, when employing the herein proposed method as described with reference to figure 2, it is possible to fully remove the bulk silicon so that the underlying structured STI is visible with bare eyes as in a), optical microscopes as well as with electron beams as in b). Moreover, figure 9 shows that the high material removal selectivity between Si and SiO can compensate for exiting non parallelism. Figure 10 visualises a perfect edge retention of the 15 µm thick free hanging corner 1000 of the IC 900 shown in figure 9. Furthermore, the structured FEOL with a thickness of a few 10 nm is optically fully intact.

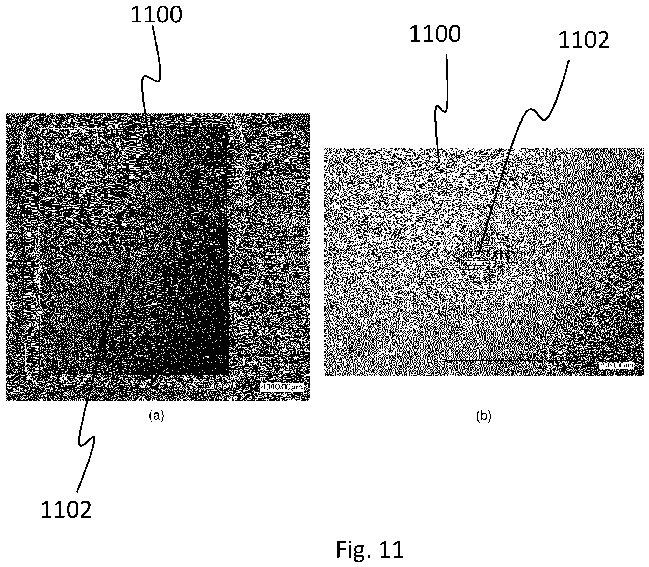

Figure 11 shows in a) and b) an optical image of a flip-chip mounted commercial sub 50 nm chip 1100 thinned down to STI level 1102 within less than four hours processing time. In particular, b) shows a zoomed excerpt of the STI level 1102 shown in a). The device 1100 shows a convex surface bending of 20 µm from the IC centre 1102 to the edges. Before thinning, the device 1100 had a thickness of 500 µm. To thin down to STI level 1102 on an area of approximately 1 mm², it took less than four hours. As shown in figure 11, the structured FEOL 1102 is clearly visible in the centre of the IC.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality.

Any reference signs in the claims should not be construed as limiting the scope.

## Claims

1. A method for backside thinning of an integrated circuit, hereinafter called IC, the method comprising the steps of:
- providing the IC, which comprises a Si-containing substrate forming the backside of the IC, a Si-based insulator-containing shallow trench isolation, hereinafter called STI, arranged on the Si-containing substrate and one or more functional IC components arranged within the STI and/or on the STI opposite the Si-containing substrate,
- providing a polishing pad,
- applying a slurry onto the polishing pad and/or the backside of the IC, the slurry being configured to provide an at least Si-selective removal upon exertion of a mechanical shear force,
- bringing the backside of the IC and the polishing pad into contact with each other, and
- thinning the IC to a thickness of the Si-containing substrate of 1 µm or less by exerting a mechanical shear force to the IC's backside while maintaining the contact between the IC and the polishing pad up.

2. The method according to claim 1, wherein the slurry comprises abrasive particles at a percentage of 5 % or less.

3. The method according to claim 2, wherein the abrasive particles, if present, have an average diameter of 100 nm or less.

4. The method according to at least one of the preceding claims, comprising - prior bringing the backside of the IC and the polishing pad into contact with each other - mechanically thinning the Si-containing substrate to a thickness of 50 µm or less.

5. The method according to at least one of the preceding claims, wherein the backside of the IC and the polishing pad are brought into contact with each other with a down pressure of 1 PSI to 20 PSI.

6. The method according to at least one of the preceding claims, wherein the thinning is carried out with a material removal rate of 0.1 µm/min to 10 µm/min.

7. The method according to at least one of the preceding claims, wherein the slurry is configured to enable a Si-to-Si-based insulator removal rate of at least 100:1.

8. The method according to at least one of the preceding claims, wherein the slurry comprises an alkali to provide the Si-selective removal.

9. The method according to at least one of the preceding claims, wherein the slurry comprises a cationic or non-ionic polymer additive that is configured to at least partially suppress static etching of Si.

10. The method according to at least one of the preceding claims, wherein the Si-containing substrate is a single crystalline, polycrystalline or amorphous Si substrate, a SiGe substrate, or a SiC substrate.

11. The method according to at least one of the preceding claims, wherein the IC has a base area of no more than 100 mm x 100 mm.

12. The method according to at least one of the preceding claims, wherein the IC is arranged on a sample holder with its backside facing away from the sample holder, wherein a distance between the IC's backside and the sample holder is at least 40 µm.

13. The method according to at least one of the preceding claims, wherein for bringing the backside of the IC and the polishing pad into contact with each other, the IC is moved towards the polishing pad.

14. The method according to at least one of the preceding claims, wherein for bringing the backside of the IC and the polishing pad into contact with each other, the polishing pad is moved towards the IC.

15. The method according to at least one of the preceding claims, comprising determining a current thickness of the Si-containing substrate at one or more selected time instances using an optical measurement.
